# EUROPEAN PATENT APPLICATION

(11) **EP 4 633 298 A1**
(43) Date of publication of application: **15.10.2025**
(21) Application number: 23900544.0
(22) Date of filing: 29.11.2023
(51) Int. Cl.: H05K 1/11, H05K 3/40

(54) **PRINTED WIRING BOARD**

(30) Priority: 06.12.2022 JP 2022195201
(71) Applicant: Fujikura Ltd., Tokyo 135-8512 (JP)
(72) Inventor: INOUE, Nobuaki, Sakura-shi, Chiba 285-8550 (JP); UETA, Nobuki, Sakura-shi, Chiba 285-8550 (JP)
(74) Representative: Ter Meer Steinmeister & Partner
(86) International application number: PCT/JP2023/042781
(87) International publication number: WO 2024/122429

(57) **Abstract**

A printed wiring board 1 includes a resin base material 10, an electrode 20 provided on the resin base material 10, and a via 30 that penetrates through the resin base material 10 to be electrically connected to the electrode 20. The via 30 includes a bismuth region 31 containing a bismuth as a main component. In the state where a cross section of the via 30 is observed by a scanning type electron microscope, a sum total of outer perimeter lengths of the bismuth regions 31 per unit area of the cross-sectional area is 0.25 µm/µm² or less.

## Description

### Technical Field

The present invention relates to a printed wiring board.

For designated countries where incorporation by reference is permitted, the content described in JP2022-195201 A filed in Japan on December 6, 2022 is incorporated by reference into this specification and becomes part of the description of this specification.

### Background Art

A via using a metal bonded type conductive paste as a mixture of a high conductive metal such as copper and argentum and a solder containing tin as a main component, and a multilayered wiring board using the via have been employed for many electronic devices as an eco-friendly wiring manufacturing technique without using a plating method for an interlayer connection. Accordingly, this technique is expected to further grow in the future. Especially, a paste via provided by combining Cu powder and Sn-Bi powder has attracted attention. The reason includes a manufacturability through a relatively low-temperature process due to the eutectic temperature of Sn-Bi as low as 139°C, and non-use of costly In and Pb that is harmful to the environment. The via made by combining the above-described materials exhibits stable connection reliability even in the high-temperature process such as the reflow and the like. Some of those techniques have been known (see, for example, Patent Document 1).

Patent Document 1 discloses the multilayered wiring substrate having the via hole conductor which includes mostly a region containing the Cu-Sn alloy as the main component surrounding a region containing Cu as the main component and a region containing Bi as the main component, each of which is included by the via hole conductor. Especially, the Cu-Sn alloy includes two types of intermetallic compounds of Cu₆Sn₅₍ₐ₎nd Cu₃Sn. It is featured that approximately 90% or more of the Cu-Sn alloy is Cu₃Sn. Patent Document 1 discloses that the use of the via hole conductor provides the via having a stable metallographic structure and high connection reliability even in the post processing that involves heating, and even after the use for a long period of time.

### Prior Art Document

### Patent Document

Patent Document 1: Japanese Patent No. 5099272

### Summary of Invention

### Problems to be Solved by Invention

Meanwhile, the recent trend of the highly densified electronic circuit demands for micronization of the conductive paste via. However, as the via structure becomes further micronized, the load exerted to the via upon the thermal shock testing is increased. The printed wiring board having the micronized via structure may cause a problem of failure due to disconnection of the via. Especially in the case of the technique as disclosed in Patent Document 1, when the via diameter becomes φ100 µm or less, and the via length becomes 50 µm or less, cracks occur from Bi regions as starting points, which are scattered while being surrounded by the Cu-Sn alloy in the via structure. This may cause the risk of increasing resistance of the via. As disclosed in Patent Document 1, the region containing Bi as the main component has an indefinite shape with more irregularities, or has a needle-like outer shape. The Bi has rigidity and strength, which are lower than those of the peripheral Cu-Sn alloy. Accordingly, the externally applied strain is concentrated on the boundary between those regions, which is likely to become the base point from where destruction occurs. This causes the problem concerning for deterioration in the strength of the boundary between the Bi and the Cu-Sn due to change in the crystal structure, caused by a local eutectic fusion reaction at the temperature around the eutectic temperature of Sn-Bi.

The present invention solves the problem by providing the printed wiring board capable of suppressing the failure caused by the via disconnection.

### Means for Solving Problems

[1] A printed wiring board according to a first aspect of the present invention includes an insulating layer, a conductive layer provided on the insulating layer, and a via that penetrates through the insulating layer to be electrically connected to the conductive layer. The via includes a bismuth region containing a bismuth as a main component. A sum total of outer perimeter lengths of the bismuth regions per unit area of a cross section of the via is 0.25/µm or less.
[2] In the printed wiring board according to a second aspect of the present invention, which is described in the first aspect, a sum total of cross-sectional areas of the bismuth regions per unit area of the cross section of the via is 0.10 or less.
[3] In the printed wiring board according to a third aspect of the present invention, which is described in the first or the second aspect, the quantity of the bismuth regions per unit area of the cross section of the via is 0.01/µm² or less.
[4] In the printed wiring board according to a fourth aspect of the present invention, which is described in any one of the first to the third aspects, the via is formed using a solder powder containing SnBi and a metal powder containing copper as a main component. A mixing ratio between the solder powder and the metal powder is in a range from 0.5 to 2.0 in a weight ratio (solder powder/metal powder).
[5] A printed wiring board according to a fifth aspect of the present invention includes an insulating layer, an electrode provided on the insulating layer, and a via that penetrates through the insulating layer to be electrically connected to the electrode. The via includes a spherical bismuth region containing a bismuth as a main component.
[6] In the printed wiring board according to a sixth aspect of the present invention, which is described in the fifth aspect, an average diameter of a cross section of the bismuth region is 4 µm or more.

### Effects of Invention

According to the present invention, it is possible to provide the printed wiring board capable of suppressing the failure caused by the via disconnection.

### Brief Description of Drawings

FIG. 1 is a cross-sectional view schematically illustrating a printed wiring board according to an embodiment of the present invention.
FIG. 2 is a cross-sectional view schematically illustrating a conventionally employed printed wiring board.
FIGS. 3(a) to 3(h) are explanatory views illustrating the process of forming a bismuth region 31 according to the embodiment of the present invention.
FIG. 4(a) illustrates a reflected electron image, captured by a scanning type electron microscope, of a cross section of a via 30 of a printed wiring board 1 according to example 1.
FIG. 4(b) illustrates a result of Bi mapping by an EDS analysis in the same visual field as that of the printed wiring board 1 according to example 1 as illustrated in FIG. 4(a).
FIG. 5(a) illustrates a reflected electron image, captured by a scanning type electron microscope, of a cross section of the via 30 of the printed wiring board 1 according to example 1.
FIG. 5(b) illustrates an image after executing a binarization process in the same visual field as that of the printed wiring board 1 as illustrated in FIG. 5(a).
FIG. 6(a) illustrates a reflected electron image, captured by a scanning type electron microscope, of a cross section of a via of a printed wiring board according to comparative example 1.
FIG. 6(b) illustrates an image after executing a binarization process in the same visual field as that of the printed wiring board according to comparative example 1 as illustrated in FIG. 6(a).
FIGS. 7(a) to 7(c) are explanatory views illustrating a method for evaluating a shape of the bismuth region 31.

### Mode(s) for Carrying out the Invention

An embodiment of the present invention will be described with reference to the drawings.

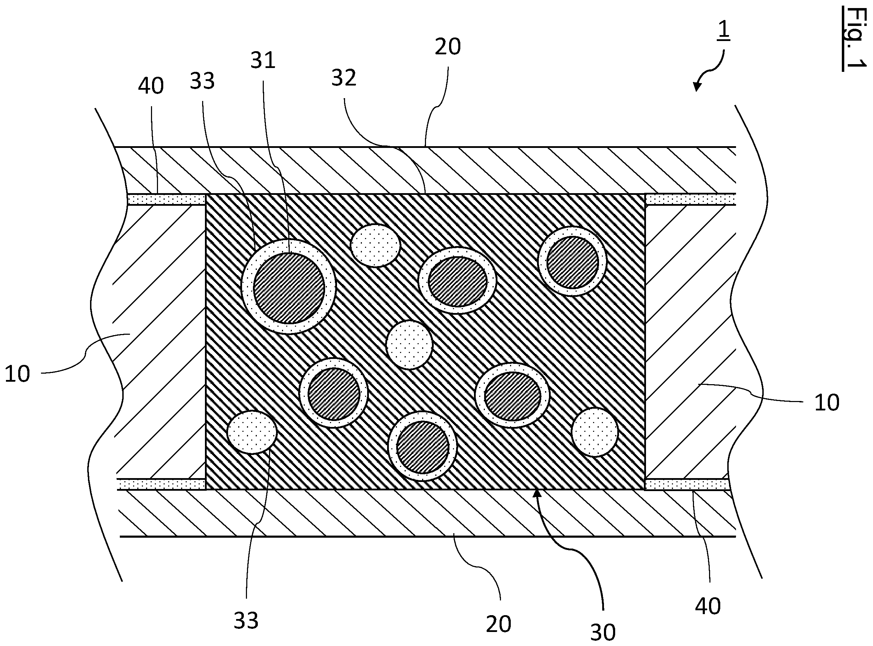

FIG. 1 is a cross-sectional view schematically illustrating a printed wiring board 1 according to an embodiment of the present invention.

The printed wiring board 1 according to the embodiment as illustrated in FIG. 1 includes a resin base material 10, an electrode 20 provided on the resin base material 10, and a via 30 that penetrates through the resin base material 10 to be electrically connected to the electrode 20. The resin base material 10 in the embodiment corresponds to an example of an "insulating layer" in the present invention, the electrode 20 in the embodiment corresponds to an example of a "conductive layer" in the present invention, and the via 30 in the embodiment corresponds to an example of a "via" in the present invention. As illustrated in FIG. 1, the printed wiring board 1 is a single layered wiring board using the single resin base material 10. The structure of the printed wiring board 1 is not specifically limited thereto, and it may also be a multilayered wiring board by stacking many resin base materials 10.

The resin base material 10 is constituted of an insulating resin material. The resin material used for constituting the resin base material 10 includes, for example, polyimide, polyethylene terephthalate, polyethylene naphthalate, polyester, liquid crystal polymer (LCP), and the like. Preferably, a thickness of the resin base material 10 is in a range from 12 to 50 µm.

The electrode 20 is constituted of a conductive material, such as copper, and formed on both surfaces of the resin base material 10. An adhesive layer 40 is provided between the electrode 20 and the resin base material 10. The electrode 20 is fixed to the resin base material 10 by the adhesive layer 40. An epoxy adhesive, but not specifically limited thereto, may be used for forming the adhesive layer 40. The electrode 20 may be formed entirely over both surfaces of the resin base material 10, or formed partially on both surfaces of the resin base material 10. **In** the case where the electrode is formed partially on both surfaces of the resin base material 10, the electrode may be formed into a predetermined pattern.

The via 30 is a conducting path for electrically connecting a pair of electrodes 20 formed on both surfaces of the resin base material 10. Preferably, an internal diameter of the via 30 is in a range from 50 to 150 µm. The length of the via 30 is equivalent to a thickness of the resin base material 10, preferably ranging from 12 to 50 µm. The via 30 according to the embodiment includes a bismuth region 31, a high melting-point metal region 32, and a resin region 33.

The bismuth region 31 includes a metal containing bismuth as the main component, and is spherically shaped. The metal other than the bismuth, which is contained in the bismuth region 31, includes Sn, SnBi, and the like. The bismuth region 31 of the via 30 can be detected by an Energy Dispersive Spectroscopy (EDS) analysis with respect to the cross section of the via 30, for example.

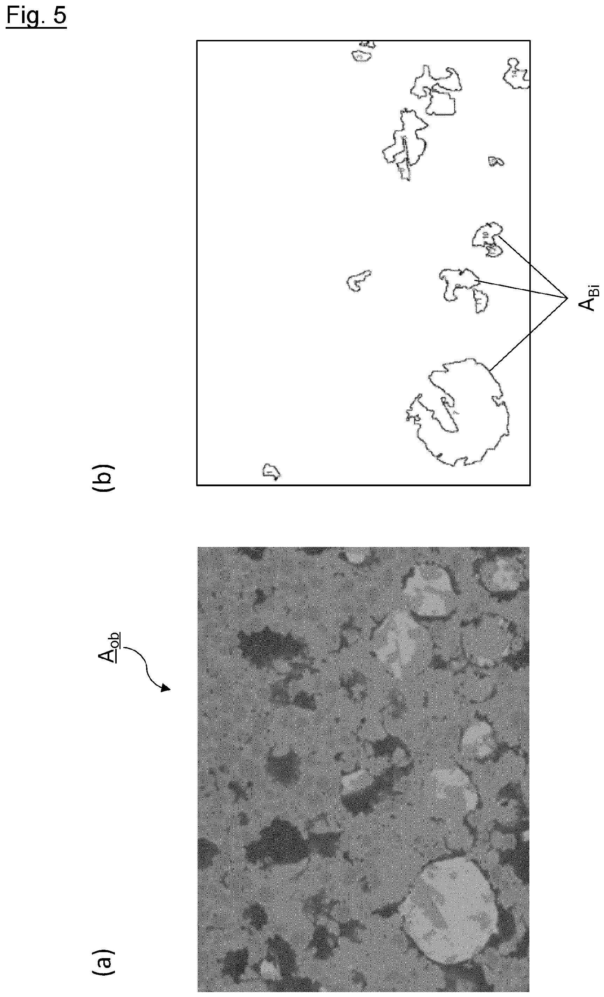

In the case where the cross section of the via 30 is observed by the scanning type electron microscope for the bismuth regions 31, the sum total of outer perimeter lengths of the bismuth regions 31 per unit area of the cross section is 0.25/µm or less (µm/µm²). More preferably, the sum total of the outer perimeter lengths of the bismuth regions 31 per unit area of the cross section of the via 30 is 0.2/µm or less, and further preferably, it is 0.15/µm or less. The lower limit of the sum total of the outer perimeter lengths of the bismuth regions 31 per unit area is not specifically limited, but preferably, it is 0.05/µm or more. The sum total of the outer perimeter lengths of the bismuth regions 31 can be measured using the reflected electron image, which is captured by the scanning type electron microscope, of the cross section of the via 30. For example, the sum total can be obtained by executing binarization process using a predetermined threshold with respect to the reflected electron image captured by the scanning type electron microscope by utilizing image analysis software (product name "ImageJ Ver. 1.52," manufactured by National Institute of Health, NIH). Specifically, the printed wiring board 1 is cut along the cross section through which the via 30 penetrates so that the cross section of the via 30 is exposed. Then the cross section of the via 30 is observed by the scanning type electron microscope to acquire an image of the cross section of the via 30. An observation region A_{ob} is set in the acquired image as illustrated in FIG. 5(a). In the observation region A_{ob}, an image analysis threshold is set to identify the bismuth containing region (whitish region relative to the other region as illustrated in FIG. 5(a)). The binarization process is executed by the image analysis to detect a bismuth region A_{Bi} as illustrated in FIG. 5(b). Each closed region as illustrated in FIG. 5(b) is the bismuth region A_{Bi} detected by the binarization process. The binarized image is subjected to the image analysis to calculate the outer perimeter length [µm] of the bismuth region A_{Bi}. Finally, the total of the outer perimeter lengths of the calculated bismuth regions A_{Bi} is calculated, and the calculated value is divided by the area [µm²] of the observation region A_{ob} to obtain the sum total [µm/µm²] of the outer perimeter lengths of the bismuth regions 31 per unit area of the cross section of the via 30. The observation region A_{ob} may be arbitrarily set to be in a range of, for example, 45 µm × 60 µm so long as the region sufficiently includes the cross section of the via 30. FIG. 5(a) illustrates the reflected electron image, which is captured by the scanning type electron microscope, of the cross section of the via 30 of the printed wiring board 1 according to example 1. FIG. 5(b) illustrates an image captured after executing the binarization process in the same visual field as the one as illustrated in FIG. 5(a). The EDS analysis is performed with respect to the observation region A_{ob} as illustrated in FIG. 5(a) to confirm that the bismuth is present in the whitish region as illustrated in FIG. 5(a). With respect to the image of the other cross section of the via 30, it is also confirmed from the EDS analysis that the bismuth is present in the whitish region.

As for the printed wiring board 1 according to the embodiment, it is sufficient that the sum total of the outer perimeter lengths of the bismuth regions 31 per unit area of the cross section of the via 30, which have been obtained based on at least one of the observation regions A_{ob}, is 0.25/µm or less. For the purpose of performing more accurate evaluation using sufficient measurement target area, it is preferable to calculate the sum total of the outer perimeter lengths of the bismuth regions 31 per unit area with respect to a plurality of observation regions A_{ob} so that an average value of the sum total values of the outer perimeter lengths of the bismuth regions 31 per unit area is 0.25/µm or less. Specifically, it is more preferable that the average value of the sum totals of the outer perimeter lengths of the bismuth regions 31 is 0.25/µm or less calculated for a range where the sum total of areas of the observation regions A_{ob} in a plurality of cross sections becomes 20000 µm² or more.

The larger the sum total of the outer perimeter lengths of the bismuth regions 31 per unit area of the cross section of the via 30, the more the bismuth region 31 is non-uniformly shaped, and the bismuth region 31 has a surface with irregular shape or a needle-like shape. In contrast, the smaller the sum total of the outer perimeter lengths of the bismuth regions 31 of the cross section of the via 30, the more the spherically shaped bismuth regions 31 are present and have less irregular surfaces.

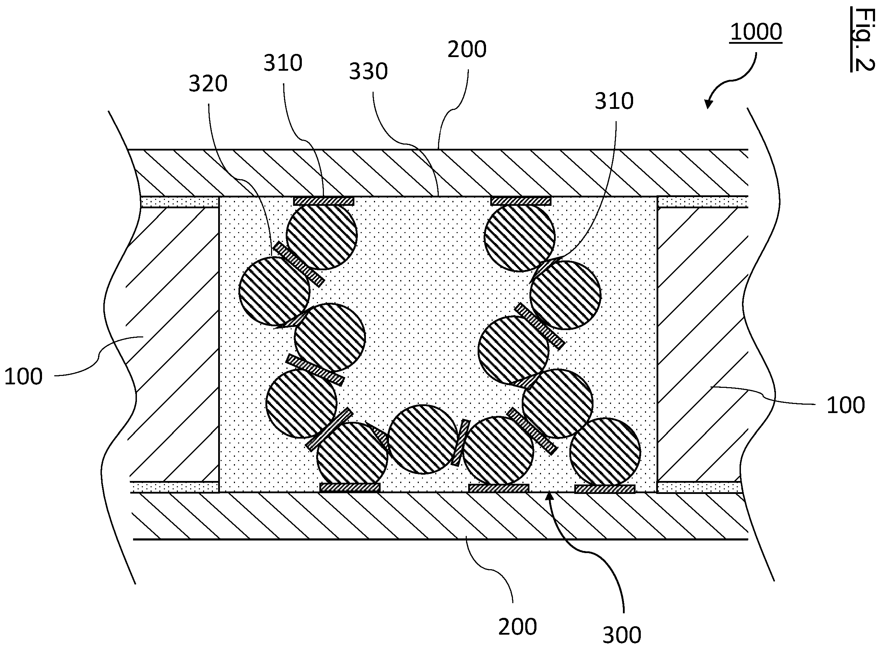

FIG. 2 is a cross-sectional view schematically illustrating a conventionally employed printed wiring board.

A conventionally employed printed wiring board 1000 as illustrated in FIG. 2 has a via 300 formed using a conductive paste that contains conductive particles, such as Cu, Sn-Bi and the like, and a resin, such as epoxy resin and the like. In the via 300, each of Bi portions 310 is shaped to have an acute portion and a protrusion as a result of heating after forming the via. The Bi portion 310 is disposed between conductors 320 (intermetallic compound particles), and positioned dispersively in contact with an electrode 200. In the via structure, upon occurrence of the thermal stress due to the difference in the thermal expansion coefficient between an insulating layer (base material) 100 and a resin 330 contained in the via 300, such stress is likely to be concentrated on the Bi portion 310 shaped to have the acute portion and the protrusion. As a result, the crack originating from the Bi portion 310 as the starting point occurs in the via 300. This caused the risk of increasing electric resistance of the via 300, and failure due to rupture of the via 300.

Meanwhile, in the printed wiring board 1 according to the embodiment, the sum total of the outer perimeter lengths of the bismuth regions 31 of the cross section of the via 30 is 0.25/µm or less, and the spherical (including the case of substantially spherical, which applies to the subsequent description) bismuth regions 31 are present in the via 30 as illustrated in FIG. 1. The stress, thus, is unlikely to be exerted to the bismuth region 31. Accordingly, it is possible to suppress disconnection of the via 30.

As the size of the via is micronized, the load caused by the thermal stress, which is applied to the via per unit volume, is likely to be greater as described above. In the printed wiring board 1 according to the embodiment, the sum total of the outer perimeter lengths of the bismuth regions 31 per unit area of the cross section of the via 30 is 0.25/µm or less. Accordingly, even in the case of micronizing the structure of the via 30 to have the internal diameter of 100 µm or less, and the length of 50 µm or less, disconnection of the via 30 can be suppressed, and the failure of the printed wiring board 1 can be suppressed.

Preferably, the sum total of the cross-sectional areas of the bismuth regions 31 per unit area of the cross section of the via 30 is 0.10 or less (µm²/µm²), and more preferably, it is 0.08 or less. The lower limit of the sum total of the cross-sectional areas of the bismuth regions 31 per unit area is not specifically limited, but it is preferable to be equal to or greater than 0.04. The sum total of the cross-sectional areas of the bismuth regions 31 can be obtained by performing the image analysis utilizing the binarization process with respect to the observation image, which is captured by the scanning type electron microscope, of the cross section of the via 30 through the method similar to the one for obtaining the sum total of the outer perimeter lengths of the bismuth regions 31. Specifically, the observation region A_{ob} is set in the acquired image, and the EDS analysis is performed with respect to the observation region A_{ob}. The binarization process is executed by the image analysis to detect the region as the bismuth region A_{Bi}, and the cross-sectional area [µm²] of the bismuth regions A_{Bi} is calculated. The total of the calculated cross-sectional areas of the bismuth regions A_{Bi} is calculated, and the calculated value is divided by the area [µm²] of the observation region A_{ob}. This makes it possible to calculate the sum total [µm²/µm²] of the cross-sectional areas of the bismuth regions 31 per unit area of the cross section of the via 30. It is sufficient that the observation region A_{ob} is set similarly to the case of obtaining the sum total of the outer perimeter lengths of the bismuth regions 31.

The larger the sum total of the cross-sectional areas of the bismuth regions 31 per unit area of the cross section of the via 30, the more the bismuth region 31 is shaped with non-uniformity, and the bismuth region 31 has a surface with irregular shape or a needle-like shape. In contrast, the smaller the sum total of the cross-sectional areas of the bismuth regions 31 of the cross section of the via 30, the more the bismuth region 31 is entirely spherically shaped with uniformity and has the surface with less irregularity. In the printed wiring board 1 according to this embodiment, the sum total of the cross-sectional areas of the bismuth regions 31 of the cross section of the via 30 is 0.10 or less. This makes it difficult to form the stress concentration point, thus allowing suppression of disconnection of the via 30.

Preferably, the quantity of the bismuth regions 31 per unit area of the cross section of the via 30 is 0.01/µm² or less, and more preferably, it is 0.008/µm² or less. The lower limit of the quantity of the bismuth regions 31 per unit area is not specifically limited, but it is preferable to be 0.003/µm² or more. The quantity of the bismuth regions 31 of the cross section of the via 30 can be obtained by the method similar to the one for obtaining the sum total of the outer perimeter lengths of the bismuth regions 31. In the method, the image analysis is performed by executing the binarization process with respect to the observation image, which is captured by the scanning type electron microscope, of the cross section of the via 30, and the quantity of detected bismuth regions 31 is counted. Specifically, the observation region A_{ob} is set in the acquired image, and the EDS analysis is performed with respect to the observation region A_{ob}. The binarization process is executed by the image analysis to detect the region as the bismuth regions A_{Bi}, and the quantity of the bismuth regions A_{Bi} is measured. The measured quantity of the bismuth regions A_{Bi} is divided by the area [µm²] of the observation region A_{ob} to obtain the quantity [number/µm²] of the bismuth regions 31 per unit area of the cross section of the via 30. The observation region A_{ob} may be set similarly to the case of obtaining the sum total of the outer perimeter lengths of the bismuth regions 31.

Although not specifically limited, the volume ratio of the bismuth region 31 to the total volume of the bismuth region 31 and the high melting-point metal region 32 is in the range from 13 to 16%. The volume ratio of the bismuth region 31 can be obtained by the measurement method such as the EDS element mapping and the like.

The high melting-point metal region 32 contains a metal or a metal compound having a melting point higher than that of the bismuth. The metal and the metal compound, which are contained in the high melting-point metal region 32, include Cu, Cu₆Sn₅₍ₐ₎nd the like. Although not specifically limited, it is preferable that the volume ratio of the high melting-point metal region 32 to the total volume of the bismuth region 31 and the high melting-point metal region 32 is in the range from 84 to 87%. The volume ratio of the high melting-point metal region 32 can be obtained by the measurement method such as the EDS element mapping and the like.

The resin region 33(c)ontaining resin is scattered inside the high melting-point metal region 32. Although not specifically limited, it is preferable to use the epoxy resin as the resin to be contained in the resin region 33(b)ecause of excellent heat resisting property and low linear expansion coefficient. A part of the resin regions 33(e)ncloses the bismuth region 31 as illustrated in FIG. 1.

Some of the bismuth regions 31 included in the via 30 of the printed wiring board 1 according to the embodiment are spherically shaped. The method described below is used for determination whether the bismuth region 31 is spherically shaped. The cross section of the via 30 is measured by the scanning type electron microscope, and the EDS analysis is performed with respect to the acquired image to identify the region containing the bismuth. The resin region present around the region, which includes the bismuth, is detected. Based on the shape of the resin region around the region including the bismuth, the cross section shape of the bismuth region is identified. It is then determined whether or not the cross section of the bismuth region has a circular shape.

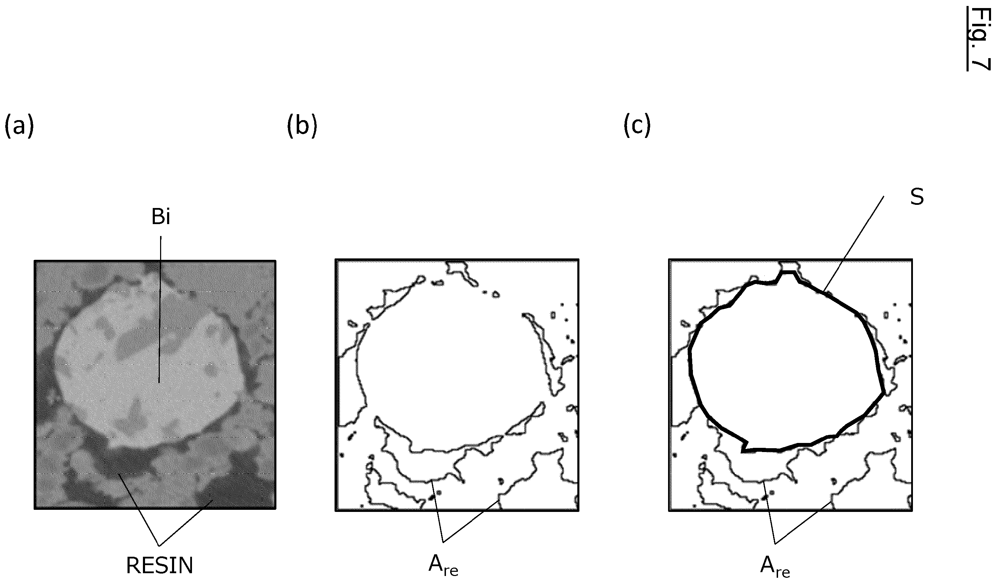

The method for evaluating the shape of the bismuth region 31 will be described in detail with reference to FIGS. 7(a) to 7(c). FIGS. 7(a) to 7(c) are explanatory views illustrating the method for evaluating the shape of the bismuth region 31. The cross section of the via 30 is measured by the scanning type electron microscope, and the EDS analysis is performed with respect to the acquired image to identify the bismuth containing region as illustrated in FIG. 7(a). As illustrated in FIG. 7(a), it is confirmed that the whitish region includes the bismuth by the EDS analysis. Focusing on the resin region surrounding the bismuth containing region, the image analysis is performed to execute the binarization process by setting the threshold so as to detect the resin region. As illustrated in FIG. 7(b), the resin region Aᵣₑ shown in FIG. 7(a) is detected. The resin regions Aᵣₑ adjacent to one another are connected in a shortest distance as illustrated in FIG. 7(b) to form a provisional region S as illustrated in FIG. 7(c). It is assumed that the provisional region S corresponds to the cross section of the bismuth region 31. It is assumed that the outer perimeter of the provisional region S corresponds to the outer perimeter of the cross section of the bismuth region 31. At this time, the provisional region S includes the solid solution portion other than the bismuth as indicated by the image of FIG. 7(a), but this is also assumed to be the bismuth region 31. The provisional region S is compared with the result of the EDS analysis. When the ratio of the bismuth element in the provisional region S is equal to or higher than 50%, it can be confirmed that the provisional region S corresponds to the bismuth region 31. After confirming that the provisional region S is the bismuth region 31, based on the outer perimeter and the area of the provisional region S, the circularity of the provisional region S is obtained. When the circularity of the provisional region S is equal to or greater than 0.8, it can be determined that the cross section of the bismuth region 31 has a circular shape. Accordingly, it can be determined that the bismuth region 31 has the spherical shape. Alternatively, an aspect ratio of the provisional region S is obtained. When the aspect ratio is 1.4 or less, it can be determined that the cross section of the bismuth region 31 has the circular shape, and the bismuth region 31 has the spherical shape. It is preferable that 80% or more of the bismuth regions 31 included in the via 30 are spherically shaped. Specifically, 10 or more provisional regions S are evaluated, and preferably, 80% or more of those regions are spherically shaped. After implementing the above-described method to verify the shape of the bismuth region 31 in the example, the presence of the spherical shape was confirmed.

Preferably, an average diameter of the cross section of the bismuth region 31 is 4 µm or more, and more preferably, equal to or larger than 7 µm. Not specifically limited, but normally, the upper limit of the average diameter of the cross section of the bismuth region 31 is equal to or smaller than 10 µm. When the average diameter of the cross section of the bismuth region 31 is too small, there may occur the risk that the entire strength of the via 30 is deteriorated. The average diameter of the cross section of the bismuth region 31 is calculated as described below. The cross section of the via 30 is observed, and the image is captured by the scanning type electron microscope. The observation region A_{ob} is set in the acquired image. A plurality of bismuth regions 31 are detected by the image analysis through execution of the binarization process with respect to the observation region A_{ob} in the similar manner as described above. For the detected plurality of bismuth regions 31, the internal diameters of the plurality of bismuth regions 31 is obtained, corresponding to the diameter of circle approximated to the diameter of the circle having the same cross-sectional area. An average value of the thus obtained internal diameters of the cross sections of the bismuth regions 31 is calculated as the average diameter of the cross section of the bismuth region 31. The observation region A_{ob} can be set to the region that includes a plurality of bismuth regions 31 (for example, including 10 or more bismuth regions 31). For example, however, it can be set similarly to the case of obtaining the sum total of the outer perimeter lengths of the bismuth regions 31.

The printed wiring board 1 that includes the via 30 having the above-described bismuth regions 31 can be manufactured using the solder powder containing Sn and Bi, and the metal powder containing copper as the main component. The printed wiring board 1 according to the embodiment is manufactured by the processes of filling a through hole 11 of the resin base material 10 with the conductive paste that includes the solder powder containing Sn and Bi, the metal powder containing copper as the main component, the epoxy resin, and the like, stacking the electrode 20 onto the resin base material 10, pressurizing the stacked body constituted by the resin base material 10 and the electrode 20, and heating the stacked body while pressurizing. The printed wiring board is then manufactured.

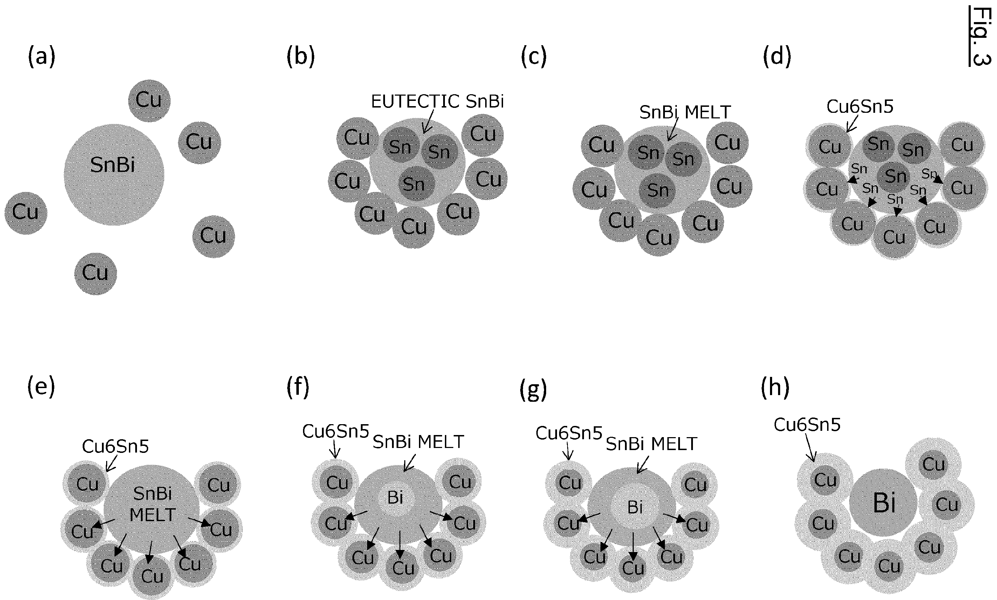

FIGS. 3(a) to 3(h) illustrate the process of forming the bismuth region 31 according to the embodiment.

It is considered that the reason why the bismuth region 31 in the via 30 of the printed wiring board 1 according to the present embodiment has a spherical shape is that the bismuth region 31 is formed through the following process. As illustrated in FIG. 3(a), the conductive paste includes the solder powder containing Sn and Bi, and the metal powder containing copper as the main component. The through hole 11 of the resin base material 10 is filled with the conductive paste, and the resin base material 10 is subjected to the press working for pressurization to bring the solder powder and the metal powder into tight contact with each other as illustrated in FIG. 3(b). The resin base material 10 is heated while being pressurized to melt the solder powder into the state where the solid phase Sn and the Sn-Bi melt coexist as illustrated in FIG. 3(c). In this condition, as the resin base material 10 is pressed at high pressure, the metal particles are in tight contact with one another. Accordingly, the Sn-Bi melt is kept in the droplet state without permeating between the metal particles. Then Sn in the melt diffuses on the surface of the metal powder (Cu) as illustrated in FIG. 3(d) to make Sn and Cu alloyed. As a result, Cu₆Sn₅ is formed on the surface of the metal powder. At this time, the solid phase Sn melts to compensate for the amount of Sn diffused to the metal powder. As the mass transfer in the melt is faster than the diffusion, the melt composition is kept uniform. At a stage where the eutectic ratio of Sn-Bi melt composition becomes Bi:Sn = 53:43(a)ll the solid phase Sn is dissolved as illustrated in FIG. 3(e). As the diffusive outflow of Sn is continued, the concentration of Bi in the Sn-Bi melt is gradually increased to start precipitation of the solid phase Bi as illustrated in FIG. 3(f). As the diffusive outflow of Sn progresses, the solid phase Bi grows while holding the spherical shape to decrease the volume of Sn-Bi melt as illustrated in FIG. 3(g). Finally, as illustrated in FIG. 3(h), all Sn in the Sn-Bi melt is entirely diffused to the metal powder, and the remaining Bi is solidified while holding the spherical shape. The bismuth region 31 is formed in this way, and the printed wiring board 1 as illustrated in FIG. 1 is manufactured.

It should be noted that, through the formation process illustrated in FIGS. 3(a) to 3(h), this kind of bismuth region 31 is formed, and as a result, the printed wiring board 1 shown in FIG. 1 is manufactured. As an example, a method is exemplified in which manufacturing and related processes are carried out using a conductive paste containing the following metal powder and solder powder in the following manner under the conditions described below.

Preferably, the metal powder contains copper as the main component by 80 to 90 wt.%. Preferably, the metal powder is subjected to oxidation resistant treatment using either the metal oxidation resistant film, the resin oxidation resistant film, or the like.

Preferably, the metal powder as a diffusion impeding element contains at least one metal element selected from a group consisting of Ti, V, Cr, Mn, Co, Ni, and Zn. Preferably, the content of the diffusion impeding element is in the range from 0.5 to 10 wt.% with respect to 100 wt.% of the metal powder. As the metal powder contains the diffusion impeding element, the process of alloying Sn and Cu (generation of Cu₆Sn₅) progresses at a relatively lower rate from the surfaces of the metal powder, which facilitates condensation of Bi in the SnBi melt. As a result, the bismuth region 31 is formed with the shape more approximate to a sphere.

Preferably, the mixing ratio between the solder powder and the metal powder is in the range from 0.5 to 2.0, and more preferably, from 1.0 to 1.5 in the weight ratio (solder powder/metal powder).

Preferably, the pressurizing condition for the process for forming the via 30 is equal to or higher than 2 MPa, and more preferably, in the range from 2 to 6 MPa. By setting the pressurizing condition to be in the above-described range, the process of alloying Sn contained in the solder powder and Cu contained in the metal powder is accelerated. The resistance value of the via 30 is lowered to improve the connection reliability of the via 30. When the pressurizing condition for forming the via 30 is less than 2 MPa, Sn and Cu are not alloyed.

As a result, the resistance value of the via 30 becomes high, which is likely to deteriorate the connection reliability of the via 30. When the pressurizing condition exceeds 6 MPa, the process for alloying Sn and Cu is accelerated. As a result, the bismuth region 31 is not spherically formed, which is likely to deteriorate the connection reliability of the via 30.

Preferably, the heating temperature in the process for forming the via 30 is in the range from 140 to 200 °C, and more preferably, from 170 to 190°C. When the heating temperature is too low, Sn and Cu are not alloyed. As a result, the resistance value of the via 30 becomes high, which is likely to deteriorate the connection reliability of the via 30. Meanwhile, when the heating temperature is too high, the volume of the SnBi melt is increased by heating. As this SnBi melt enters the peripheral region, the bismuth region 31 having the spherical shape is unlikely to be formed.

In the printed wiring board 1 according to the present embodiment, the sum total of the outer perimeter lengths of the bismuth regions 31 per unit area of the cross section of the via 30 is 0.25/µm or less. There exists a spherically shaped bismuth region 31 in the via 30. As a result, the stress is hardly applied to the bismuth region 31. It is therefore possible to suppress generation of failure due to the disconnection of the via 30.

### Example

Examples of the present invention will be described in detail. The present invention, however, is not limited to those examples.

### Example 1

The through holes 11 with their diameters ranging from 60 to 120 µm were formed by laser in the polyimide resin base material 10 having its thickness ranging from 12 to 25 µm, and the through holes 11 were filled with the conductive paste with the composition as described below. The conductive paste containing the Sn-Bi based solder powder, the oxidation resistant treated copper powder, and the epoxy resin was used, having the mixing ratio between the solder powder and the copper powder set to 1.3 in the weight ratio of the solder powder/copper powder. The copper powder containing the diffusion impeding element was used. The epoxy adhesive was applied to both surfaces of the resin base material 10, to which a copper foil with its thickness of 12 µm was applied as the electrode 20. The resultant stacked body was pressed by the hot press machine under the pressurizing condition from 2 to 6 MPa, and kept for 110 minutes. For 60 minutes of the total time taken for pressing using the hot press machine, the heating process was executed at the temperature from 150 to 200°C while holding the stacked body in the pressurized state to acquire the printed wiring board 1 having the via 30.

### <Energy Dispersive Spectroscopy (EDS) analysis>

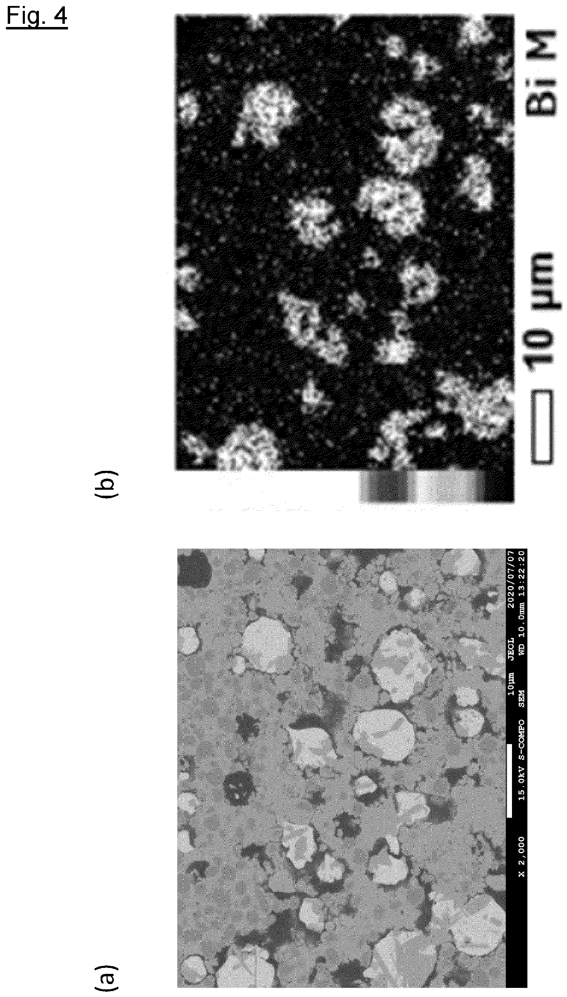

The printed wiring board 1 was cut along the direction perpendicular to the resin base material 10 to expose the cross section of the via 30. The scanning type electron microscope (product name "JSM-7001F," manufactured by JEOL) was used to capture a reflected electron image of the cross section of the via 30, and the EDS analysis was performed for component analysis. The measurement conditions were set at 15 kV output and 2000x magnification. As illustrated in the reflected electron images in FIGS. 4(a) and 4(b), it was confirmed that Bi atoms are contained in the whitish region relative to the other region, having a circular cross section. FIG. 4(a) illustrates the reflected electron image, which is captured by the scanning type electron microscope, of the cross section of the via 30 of the printed wiring board 1 according to example 1. FIG. 4(b) illustrates Bi mapping results obtained by the EDS analysis in the same visual field of the printed wiring board 1 according to example 1 as illustrated in FIG. 4(a).

### <Measurement of outer perimeter length, cross-sectional area, and the quantity of bismuth regions 31>

The printed wiring board 1 was cut along the direction perpendicular to the resin base material 10 to expose the cross section of the via 30. The scanning type electron microscope was used to capture reflected electron images of eight arbitrary points of the cross section of the via 30. The measurement conditions were set at 15 kV output and 900x magnification. For each of the acquired images, a visual field having an image size of 588 pixel × 441 pixel = 60 µm × 45 µm was set to an observation region A_{ob} so as to be subjected to an image analysis using image analysis software (product name "ImageJ Ver. 1.52," manufactured by National Institute of Health, NIH). In the condition where the lower limit and the upper limit of gradation divided into 256 steps were set to 150 and 175, respectively, the binarization process was executed. The thresholds set as described above allowed detection of the bismuth region A_{Bi} containing the bismuth as the main component. The outer perimeter lengths [µm] and the cross-sectional areas [µm²] of the bismuth regions A_{Bi} detected by the binarization process were obtained from the image analysis. The sum total [µm] of the outer perimeter lengths of the respective bismuth regions 31 was divided by the area [µm²] of the observation region A_{ob} to obtain the sum total [/µm] of the outer perimeter lengths of the bismuth regions 31 per unit area of the cross section of the via 30. Similarly, the sum total [µm²] of the cross-sectional areas of the respective bismuth regions A_{Bi} was divided by the area [µm²] of the observation region A_{ob} to obtain the sum total [-] of the cross-sectional areas of the bismuth regions 31 per unit area of the cross section of the via 30. The quantity of the bismuth regions A_{Bi} detected by the binarization process was counted. The counted number was divided by the area [µm²] of the observation region A_{ob} to obtain the quantity [number/µm²] of the bismuth regions 31 per unit area of the cross section of the via 30. The sum total of the outer perimeter lengths of the bismuth regions per unit area, the sum total of the cross-sectional areas per unit area, and the quantity of the bismuth regions per unit area were obtained with respect to the eight observation regions A_{ob}, and the respective average values were obtained. Table 1 shows obtained results. FIG. 5(a) illustrates the reflected electron image, which is captured by the scanning type electron microscope, of the cross section of the via 30 of the printed wiring board 1 according to example 1. FIG. 5(b) illustrates an image after execution of the binarization process in the same visual field of the printed wiring board 1 as illustrated in FIG. 5(a).

### <Thermal shock test>

A thermal shock test was performed with respect to a plurality of test samples each as the obtained printed wiring board 1 using a temperature cycle tester system (product name "WINTECH," manufactured by ETAC). The test was performed under the conditions of temperature range from -40 to +85°C, a test period of 30 minutes, and the number of cycles set to 250, 500, 750, 1000. For every 250 cycles, an incidence rate of the defect rate was measured. The defect rate refers to the rate of test samples having resistance failure occurred. Table 3 shows the test results.

### <Examples 2 to 4>

The printed wiring board 1 was obtained similarly to example 1 except that the mixing ratio between the solder powder and the copper powder of the conductive paste was changed to 1.1, 1.2, and 1.4 in the weight ratio of the solder powder/copper powder. Evaluation was performed with respect to the outer perimeter length, the cross-sectional area, and the quantity of the bismuth regions 31 of the obtained printed wiring board 1 similarly to example 1. In each of the printed wiring boards 1, the sum total of the outer perimeter lengths of the bismuth regions 31 per unit area of the cross section of the via was 0.25/µm or less, the sum total of the cross-sectional areas of the bismuth regions 31 per unit area of the cross section of the via was 0.10 or less, and the quantity of the bismuth regions 31 per unit area of the cross section of the via was 0.01/µm² or less. The thermal shock test was performed with respect to those printed wiring boards 1. Table 3 shows the test results.

### <Comparative example 1>

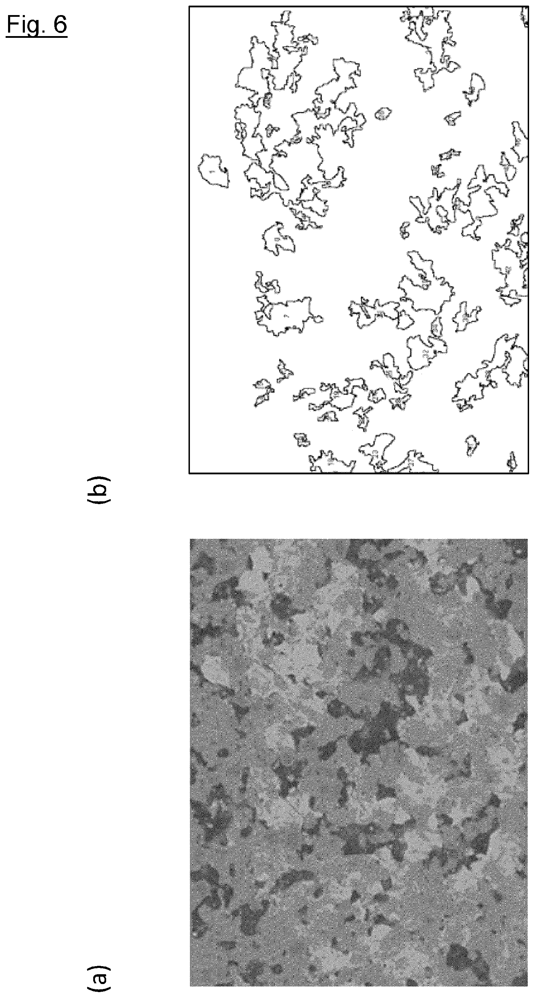

The printed wiring board 1 was obtained similarly to example 1 except that copper powder not containing any diffusion impeding element was used in the conductive paste. The cross section of the via 30 was evaluated, and the thermal shock test was performed similarly to example 1. Tables 2 and 3 show the respective results. FIG. 6(a) illustrates a reflected electron image, which is captured by the scanning type electron microscope, of the cross section of the via of the printed wiring board according to comparative example 1. FIG. 6(b) illustrates an image after the execution of the binarization process in the same visual field of the printed wiring board according to comparative example 1 as illustrated in FIG. 6(a).

### [Table 1]

**Table 1**

| | | Example 1 | | | | | | | | |
|---|---|---|---|---|---|---|---|---|---|---|
| Observation region A_{ob} number | | 1 | 2 | 3 | 4 | 5 | 6 | 7 | 8 | Average value |
| Quantity of bismuth regions A_{Bi} | [number] | 14 | 20 | 20 | 27 | 22 | 27 | 27 | 17 | 21.8 |
| Sum total of cross-sectional areas of bismuth regions A_{Bi} | [µm²] | 204.5 | 209.1 | 310.7 | 308 | 282.8 | 191.2 | 233.9 | 225.6 | 245.7 |
| Sum total of outer perimeter lengths of bismuth regions A_{Bi} | [µm] | 263.1 | 302.8 | 463.2 | 589.9 | 461.7 | 324 | 374.7 | 392.4 | 396.5 |
| Area of observation region A_{ob} | [µm²] | 2700 | 2700 | 2700 | 2700 | 2700 | 2700 | 2700 | 2700 | 2700 |
| Quantity of bismuth regions A_{Bi} per unit area | [number/µm²] | 0.005 | 0.007 | 0.007 | 0.010 | 0.008 | 0.010 | 0.010 | 0.006 | 0.008 |
| Sum total of cross-sectional areas of bismuth regions A_{Bi} per unit area | [-] | 0.076 | 0.077 | 0.115 | 0.114 | 0.105 | 0.071 | 0.087 | 0.084 | 0.091 |
| Sum total of outer perimeter lengths of bismuth regions A_{Bi} per unit area | [/µm] | 0.097 | 0.112 | 0.172 | 0.218 | 0.171 | 0.120 | 0.139 | 0.145 | 0.147 |

### [Table 2]

**Table 2**

| | | Comparative Example 1 | | | | | | | | |
|---|---|---|---|---|---|---|---|---|---|---|
| Observation region A_{ob} number | | 1 | 2 | 3 | 4 | 5 | 6 | 7 | 8 | Average value |
| Quantity of bismuth regions A_{Bi} | [number] | 47 | 57 | 59 | 59 | 50 | 46 | 62 | 51 | 53.9 |
| Sum total of cross-sectional areas of bismuth regions A_{Bi} | [µm²] | 488.5 | 320.6 | 373.9 | 319.9 | 320.2 | 254.4 | 307.5 | 215.4 | 325.1 |
| Sum total of outer perimeter lengths of bismuth regions A_{bi} | [µm] | 1139 | 878.2 | 958.5 | 907.6 | 767.7 | 695 | 849.3 | 623.2 | 852.3 |
| Area of observation region A_{ob} | [µm²] | 2700 | 2700 | 2700 | 2700 | 2700 | 2700 | 2700 | 2700 | 2700 |
| Quantity of bismuth regions A_{Bi} per unit area | [number/µm²] | 0.017 | 0.021 | 0.022 | 0.022 | 0.019 | 0.017 | 0.023 | 0.019 | 0.020 |
| Sum total of cross-sectional areas of bismuth regions A_{Bi} per unit area | [-] | 0.181 | 0.119 | 0.138 | 0.118 | 0.119 | 0.094 | 0.114 | 0.080 | 0.120 |
| Sum total of outer perimeter lengths of bismuth regions A_{Bi} per unit area | [/µm] | 0.422 | 0.325 | 0.355 | 0.336 | 0.284 | 0.257 | 0.315 | 0.231 | 0.316 |

### [Table 3]

**Table 3**

| | Defect rate [%] | | | | |
|---|---|---|---|---|---|
| Number of cycles | 0 | 250 | 500 | 750 | 1000 |
| Example 1 | 0 | 0 | 0 | 0 | 0 |
| Example 2 | 0 | 0 | 0 | 0 | 0 |
| Example 3 | 0 | 0 | 0 | 0 | 0 |
| Example 4 | 0 | 0 | 0 | 0 | 0 |
| Comparative Example 1 | 0 | 0 | 14 | 46 | 77 |

In the case of observing the cross section of the via of the printed wiring board 1 according to example 1 by the scanning type electron microscope, as indicated by Table 1, the sum total of the outer perimeter lengths of the bismuth regions per unit area of the cross section was 0.25/µm or less. The printed wiring board had significantly minute via 30 having its internal diameter from 60 to 120 µm, and its length from 12 to 50 µm. However, as indicated by Table 3, no defect nor disconnection of the via occurred even after executing 1000 cycles of the thermal shock test. Meanwhile, in the case of the printed wiring board according to comparative example 1, the sum total of the outer perimeter lengths of the bismuth regions per unit area of the cross section of the via exceeded 0.25/µm as indicated by Table 2. As illustrated in FIGS. 6(a) and 6(b), the resultant bismuth region was finely dispersed inside the via. In the printed wiring board according to comparative example 1, the defect occurred in the 500th cycle and subsequent cycles of the thermal shock test, and the via disconnection occurred as indicated by Table 3(a)s illustrated in FIG. 6(a), the whitish region relative to the other region corresponds to the bismuth region. As illustrated in FIG. 6(b), each closed region corresponds to the bismuth region detected by the binarization process. It was confirmed from the EDS analysis that the whitish region included the bismuth as illustrated in FIG. 6(a).

The reason for the structure of the printed wiring board obtained in comparative example 1, in which the bismuth region is finely dispersed, is considered to be as follows. In example 1, the copper powder containing the diffusion impeding element was used to delay diffusion of Sn from the Sn-Bi melt to Cu during the pressurization/heating process, and the process for alloying Cu and Sn at relatively lower rates. This caused the condensation of the solid phase Bi while holding the droplet shape of the Sn-Bi melt. Accordingly, the bismuth region had a spherical structure. In contrast, in comparative example 1, the copper powder containing no diffusion impeding element was used to accelerate diffusion of Sn to Cu and the process for alloying Cu and Sn. This caused dispersion of Bi rather than condensation. As a result, comparative example 1 was structured to have the finely dispersed bismuth region. The structure of comparative example 1 had the finely dispersed bismuth region, and the surface having more irregularities to facilitate concentration of the thermal stress on the bismuth region. It is therefore considered that the above-described factor brought unsatisfactory results of the thermal shock test.

### Description of Reference Numerals

- 1: Printed wiring board
- 10: Resin base material
- 20: Electrode
- 30: Via
- 31: Bismuth region
- 32: High melting-point metal region
- 33: Resin region
- 40: Adhesive layer

## Claims

1. A printed wiring board comprising:
an insulating layer;
a conductive layer provided on the insulating layer; and
a via penetrating through the insulating layer to be electrically connected to the conductive layer, wherein
the via includes a bismuth region containing a bismuth as a main component, and
a sum total of outer perimeter lengths of the bismuth regions per unit area of a cross section of the via is 0.25/µm or less.

2. The printed wiring board according to claim 1, wherein
a sum total of cross-sectional areas of the bismuth regions per unit area of the cross section of the via is 0.10 or less.

3. The printed wiring board according to claim 1 or 2, wherein
a quantity of the bismuth regions per unit area of the cross section of the via is 0.01/µm² or less.

4. The printed wiring board according to any one of claims 1 to 3, wherein
the via is formed using a solder powder containing SnBi and a metal powder containing copper as a main component, and
a mixing ratio between the solder powder and the metal powder is in a range from 0.5 to 2.0 in a weight ratio (solder powder/metal powder).

5. A printed wiring board comprising:
an insulating layer;
an electrode provided on the insulating layer; and
a via penetrating through the insulating layer to be electrically connected to the electrode, wherein
the via includes a spherical bismuth region containing a bismuth as a main component.

6. The printed wiring board according to claim 5, wherein
an average diameter of a cross section of the bismuth region is 4 µm or more.
